# EUROPÄISCHE PATENTSCHRIFT

(11) **EP 1 654 397 B1**
(45) Veröffentlichungstag und Bekanntmachung des Hinweises auf die Patenterteilung: **10.03.2010**
(21) Anmeldenummer: 04766367.9
(22) Anmeldetag: 29.07.2004
(51) Int. Cl.: C23C 16/44, C23C 16/455, C23C 16/453

(54) **VERFAHREN UND VORRICHTUNG ZUR BESCHICHTUNG ODER MODIFIZIERUNG VON OBERFLÄCHEN**
METHOD AND DEVICE FOR COATING OR MODIFYING SURFACES
PROCEDE ET DISPOSITIF DE REVETEMENT OU DE MODIFICATION DE SURFACES

(30) Priorität: 02.08.2003 DE 10335470
(43) Veröffentlichungstag der Anmeldung: 10.05.2006
(73) Patentinhaber: Fraunhofer-Gesellschaft zur Förderung der angewandten Forschung e.V., 80686 München (DE)
(72) Erfinder: DIECKHOFF, Stefan, 28865 Lilienthal (DE); WILKEN, Ralph, 26180 Rastede (DE)
(74) Vertreter: Eisenführ, Speiser & Partner
(86) Internationale Anmeldenummer: PCT/EP2004/051659
(87) Internationale Veröffentlichungsnummer: WO 2005/014880

(56) Entgegenhaltungen:
- EP-A- 0 324 538
- WO-A-96/24703
- HAUBNER R ET AL: "DIAMOND GROWTH BY HOT-FILAMENT CHEMICAL VAPOR DEPOSITION: STATE OF THE ART" DIAMOND AND RELATED MATERIALS, ELSEVIER SCIENCE PUBLISHERS, AMSTERDAM, NL, Bd. 2, 1993, Seiten 1277-1294, XP000867627 ISSN: 0925-9635
- MORRISH A A ET AL: "EFFECTS OF SURFACE PRETREATMENTS ON NUCLEATION AND GROWTH OF DIAMOND FILMS ON A VARIETY OF SUBSTRATES" APPLIED PHYSICS LETTERS, AMERICAN INSTITUTE OF PHYSICS, NEW YORK, US, Bd. 59, Nr. 4, 22. Juli 1991 (1991-07-22), Seiten 417-419, XP000241516 ISSN: 0003-6951
- SPICKA H ET AL: "Investigations of the incorporation of B, P, N into CVD-diamond films by secondary ion mass spectroscopy" DIAMOND AND RELATED MATERIALS, Bd. 5, 1996, Seiten 383-387, XP004080660 ELSEVIER SCIENCE PUBLISHERS, AMSTERDAM, NL

## Beschreibung

Die vorliegende Erfindung betrifft ein Verfahren zur Beschichtung oder Modifizierung von Oberflächen.

Zur Beschichtung von Oberflächen mit möglichst dünnen Schichten im Bereich von 0,5nm bis 50µm, um z.B. die Korrosionsbeständigkeit des zu beschichtenden Materials oder die Hafteigenschaften der Oberfläche zu verändern, sind Gasphasenschichtabscheidungen oder auch CVD-Verfahren (Chemical Vapor Deposition Verfahren) bekannt. Bei der Gasphasenschichtabscheidung wird regelmäßig eine Gasphase angeregt, innerhalb der Gasphase laufen physikalisch-chemische Prozesse ab, und als Folge werden dünne Schichten auf Substraten erzeugt Die Temperaturen liegen bei diesen Prozessen in der Regel zwischen 200 und 2000°C. Je nach Art der Energiezufuhr spricht man von thermischen, plasma-, photonen- oder laseraktivierten Gasphasenschichtabscheidungen. Die Gaskomponenten werden üblicherweise mit einem Trägergas bei Drücken zwischen 10 mbar und 1 bar durch eine Reaktionskammer geleitet, in der die physikalisch-chemischen Prozesse stattfinden und in der sich die dabei gebildeten Festkörperkomponenten als dünne Schicht auf Substraten abscheiden. Die flüchtigen Nebenprodukte werden mit dem Trägergas abgeführt.

Bei Gasphasenschichtabscheidungen, bei denen sogenannte kalte Plasmen zur Energiezufuhr genutzt werden, wird bei niedrigen Drücken gearbeitet, die deutlich unter dem Druck der Atmosphäre von etwa 1 bar liegen.

Aus der DE 102 36 430 ist ein thermisches Verfahren zur Niedertemperatur-Gasphasenabscheidung bekannt, bei der die Beschichtung innerhalb einer Reaktionskammer erfolgt. Die Reaktionskammer ist an eine Pumpe angeschlossen, die zum Regeln des Drucks und Entfernen von Nebenprodukten und überschüssigen Gasen aus der Reaktionskammer dient.

Weiterhin sind auch Verfahren bekannt, bei denen ein sogenanntes thermisches Plasma zum Beschichten verwendet wird. Bei diesen Verfahren, die auch als Plasmaspritzverfahren bezeichnet werden, kann unter Atmosphärendruck gearbeitet werden, so dass eine spezielle Druckkammer also nicht erforderlich ist. Im Plasmaspritzverfahren wird ein Gas in einer Bogenentladung hoher Leistung, nämlich 5 bis 100 kW auf eine hohe Temperatur von 400 bis 10.000 K gebracht, um Metall oder Keramikteilchen, die in die Entladung gebracht werden und im heißen Gasstrom Schmelztropfen bilden, auf Geschwindigkeiten von über 100 m/s zu beschleunigen. Die heißen Schmelztropfen erstarren beim Aufprall auf der zu beschichtenden Oberfläche und bilden dort die gewünschte Schicht. Die Schichtdicke bei Plasmaspritzverfahren liegt zwischen 100µm und einigen mm.

Aus der DE 199 55 880 ist ein Verfahren zur plasmaaktivierten Abscheidungen von Schichten in sogenannten Barriere- oder Coronaentladungen bei Atmosphärendruck bekannt. Hierbei wird eine Coronaentladung zwischen einer oder mehreren Elektroden und dem Substrat, das metallisch leitfähig sein muss, gezündet. Hierdurch wird die Beschichtung auf die Oberfläche des Substrates gebracht. Vgl. auch DE 195 15 069 und DE 195 05 449.

Aus dem Japanese Journal of Applied Physics, Vol. 21, Nr. 4, 1982, L183 bis L185 ist eine Gasphasenabscheidung von Diamantenpartikeln bekannt, bei der die zur Abscheidung notwendige Aktivierung eines Methan-Wasserstoff-Gemisches mittels eines heißen Filamentes erfolgt. Die Abscheidung zur Beschichtung erfolgt in einer Unterdruckkammer, in der der Druck während der Beschichtung zwischen etwa 1/100 und 1/10 bar liegt und die Flussrate ca. 10 ml/min beträgt. Die Unterdruckkammer wird außerdem durch einen außerhalb der Kammer gelegenen Ofen beheizt. In der WO 00/47795 wird ebenfalls eine Gasphasenabscheidung mit Hilfe eines heißen Filamentes in einer Reaktionskammer beschrieben; das Substrat ist dabei einem Druck von etwa 40 Torr ausgesetzt. Vgl. auch EP 0637639, US 5256206, EP 0561511, US 5079038 und JP 2092895.

Aus der DE 198 07 086 ist ein Verfahren zum Beschichten von Oberflächen eines Substrates bekannt, bei dem eine erste Gasphase mittels eines elektrischen Feldes in einen Plasmazustand versetzt wird und einen Plasmastrahl bildet. In diesen Plasmastrahl wird dann eine zweite Gasphase eingebracht, welche einen oder mehrere Prekursoren, ein Aerosol und/oder einen pulverförmigen Feststoff enthält, und durch physikalisch-chemische Reaktionen zwischen der plasmaaktivierten Gas-phase und der zugemischten Gasphase werden zur Schichtabscheidung geeignete Teilchenspezies gebildet. Diese Teilchenspezies werden zur Schichtabscheidung mit dem Plasmastrahl auf das zu beschichtende Substrat transportiert und bilden auf diesem eine Schicht. Das Verfahren ist unter Atmosphärendruck durchführbar. Zur Erzeugung des elektrischen Feldes, das notwendig ist, um die Gasphase in den Plasmazustand zu überführen, sind Hochspannungselektroden erforderlich. Die Spannung zur Erzeugung des elektrischen Feldes liegt beispielsweise bei 12 kV und weist eine sinusförmige Frequenz von 20 kHz auf.

Die aus dem Stand der Technik bekannten Beschichtungsverfahren sind - sofern sie überhaupt zum Bilden dünner Schichten geeignet sind - insoweit nachteilig, als zu ihrer Durchführung ein hoher apparativer Aufwand erforderlich ist. Die meisten der vorstehend genannten Verfahren, und zwar insbesondere die hot-filament-Verfahren, benötigen eine druckdichte Reaktionskammer. Das führt dazu, dass eine entsprechende Pumptechnik erforderlich ist, um die notwendigen Druckverhältnisse in der Reaktionskammer einstellen zu können. Weiterhin sind Investitionskosten für Rezipienten erforderlich. Als weiterer Nachteil erwächst aus der Notwendigkeit einer Reaktionskammer, dass das Substrat, dessen Oberfläche zu beschichten ist, in der Reaktionskammer angeordnet sein muss. Dies führt wiederum dazu, dass ein solches Verfahren grundsätzlich diskontinuierlich arbeiten muss, wenn Substratchargen nacheinander beschichtet werden sollen. Es kommt hinzu, dass die Größe der Reaktionskammer auf die Größe des Substrats abgestimmt sein muss. Aus dem hohen apparativen Aufwand resultiert ebenfalls ein hoher manueller Aufwand für die Durchführung des Verfahrens, sofern nicht eine kostenintensive Automatisierung in einer komplexen Beschichtungsanlage umgesetzt wird.

Wenngleich das Verfahren, das in der DE 198 07 086 beschrieben ist, keine geschlossene Reaktionskammer benötigt, so ist doch auch hier der apparative Aufwand noch hoch. Insbesondere erfordert das Erzeugen eines elektrischen Feldes die Bereitstellung einer Hochspannungsquelle. Neben der Hochspannungsquelle, die gemäß der genannten Druckschrift als Generator bereitgestellt wird, müssen ebenfalls geeignete Hochspannungselektroden bereitgestellt werden. Um ein hohes elektrisches Feld zu erreichen, muss zwischen den Elektroden eine hohe Spannung und ein möglichst geringer Abstand vorliegen. Die Ausbildung einer ungewollt heißen Entladung oder Bogenentladung zwischen den Elektroden, die zur Zerstörung der Elektroden und des Substrats führen kann, kann dadurch vermieden werden, dass die Strömung der Gasphase, die in den Plasmazustand versetzt werden soll, mit der zeitlich variablen Spannung an den Elektroden abgestimmt ist. Dabei können auch ein Dielektrikum oder mehrere Dielektrika zwischen den Elektroden und dem Plasma zusätzlich vorgesehen werden.

Die Bereitstellung des elektrischen Feldes ist somit aufwendig und schwierig. Die Herstellung der Vorrichtung insbesondere im Bereich der Elektroden erfordert eine hohe Genauigkeit. Es kommt hinzu, dass bei der Durchführung des Verfahrens die elektrische Spannung zur Erzeugung des elektrischen Feldes genau auf den dazwischen geführten Gasstrom abzustimmen ist. Weiterhin ist zu beachten, dass aus der Verwendung von Hochspannung ebenfalls besondere Sicherheitsanforderungen erwachsen, die entsprechende Sicherheitsvorkehrungen notwendig machen.

Die EP 0 324 538 A1 offenbart ein Beschichtungsverfahren, bei dem das zu beschichtende Substrat in einer Flamme platziert wird und somit hoher thermischer Belastung ausgesetzt ist. Die WO 96/24703 beschreibt ein Beschichtungsverfahren unter Vakuumbedingungen.

Der Erfindung liegt daher die Aufgabe zugrunde, ein Verfahren zum Beschichten oder Modifizieren von Oberflächen zu schaffen, das gegenüber bekannten Verfahren einen geringeren Aufwand erfordert und eine höhere Flexibilität der Anwendung ermöglicht. Erfindungsgemäß wird ein Verfahren zum Beschichten oder Modifizieren einer Oberfläche wie im Anspruch 1 beschrieben angegeben: Bevorzugte Gasphasen sind dabei zB. Luft, Stickstoff, Argon, Schwefelhexafluorid.

Unter Aerosol ist hierbei jegliches Gas oder Gasgemisch zu verstehen, das darin dispergierte feste und/oder flüssige Teilchen als sogenannte Schwebstoffe enthält,

Gemäß dem oben genannten Schritt b) wird bei der ersten Alternative die erste Gasphase oder das Aerosol, die bzw. das eine oder mehrere Prekursor-Verbindungen umfasst, an einem ersten erhitzten Filament entlang geführt, so dass die mindestens eine Prekursor-Verbindung in die mindestens eine reaktive Verbindung überführt wird.

Gemäß der zweiten Alternative werden zunächst nicht-aktivierte Teilchen entlang eines ersten und/oder zweiten (und/oder eines oder mehrerer weiterer) Filamente geführt und so aktiviert. Die aktivierten Teilchen werden dann mit der ersten Gasphase oder dem ersten Aerosol zusammengeführt, so dass sie mit den Prekursor-Verbindungen unter Bildung von reaktiven Verbindungen reagieren.

Die beiden Alternativen können außerdem kombiniert werden, so dass ein Teil der reaktiven Verbindungen gemäß der ersten dargestellten Altemative und ein weiterer Teil der reaktiven Verbindungen gemäß der zweiten dargestellten Alternative entstehen.

In Schritt c) werden die gemäß Schritt b) gebildeten reaktiven Verbindungen oder zumindest ein Teil von ihnen auf ein Substrat geleitet, so dass sich auf diesem Substrat eine Schicht abscheidet oder dessen Oberfläche modifiziert wird. Hierbei ist das Substrat Atmosphärendruck ausgesetzt, was bedeutet, dass keine druckdichte Abschirmung des Substrates gegen die Umgebung vorgenommen wird. Dabei ist unter der Umgebung der Raum zu verstehen, in dem das Verfahren eingesetzt wird, wie beispielsweise eine Fertigungshalle, ein Labor oder auch ein Arbeitsplatz unter freiem Himmel. Auf den genauen Wert für den Atmosphärendruck kommt es nicht sonderlich an, jedoch wird das Verfahren erfindungsgemäß gerade nicht in einer speziellen Druckkammer bzw. Unterdruckkammer durchgeführt, wenngleich dies natürlich auch möglich ist.

Das Verfahren ist in normaler Luftumgebung betreibbar. Zu beachten ist, dass zwar der Druck am Substrat dann etwa dem Atmosphärendruck entspricht, jedoch der Druck am Filament deutlich höher sein kann.

In einer bevorzugten Ausführung ist das erfindungsgemäße Verfahren **dadurch gekennzeichnet, dass** die erste Gasphase oder das erste Aerosol mindestens ein Inertgas und/oder Luft enthält. Durch die Verwendung von Luft und/oder mindestens einem Inertgas, wie z.B, Ar, N₂ oder SF₆, kann insbesondere die Umwandlung reaktiver Verbindungen in nicht-reaktive Verbindungen verzögert werden.

Ebenso wie die Wahl der Strömungsgeschwindigkeit der die reaktiven Verbindungen enthaltende Strömung beeinflusst die Wahl der Zusammensetzung von Gasphase(n) und/oder Aerosol(en) die mittlere Weglänge der reaktiven Verbindungen, bis sie in nicht-reaktive Verbindungen umgewandelt werden.

Im erfindungsgemäßen Verfahren wird Schritt b) in einem Strömungshohlkörper durchgeführt, der die Strömung der er-sten Gasphase oder des Aerosols bzw. der nicht-aktivierten Teilchen führt. Hierdurch kann auf einfache Weise die Breite, die Größe und/oder die Richtung der Strömung vorgegeben werden. Vorzugsweise ist das bzw. sind die Filamente in dem Strömungshohlkörper befestigt, so dass die erste Gas-phase oder das erste Aerosol und/oder die nicht-aktivierten Teilchen an dem bzw. den entsprechenden Filament(en) entlang geführt werden,

Das zu beschichtende oder zu modifizierende Substrat wird außerhalb des Strömungshohlkörpers angeordnet.

Hierbei wird die Strömung, die die reaktiven Verbindungen trägt, vorteilhafterweise mittels des Strömungshohlkörpers auf das Substrat gerichtet Das Substrat kann hierbei unabhängig von den Dimensionen des Strömungshohlkörpers beliebig groß ausgebildet sein. Zum Beschichten eines großflächigen Substrates kann der Auslass des Strömungshohlkörpers an der zu beschichtenden Oberfläche entlang geführt werden und/oder das Substrat kann an dem Auslass des Strömungshohlkörpers entlang geführt werden, so dass die Strömung, die die reaktiven Verbindungen trägt, und somit die reaktiven Verbindungen selbst jeden Bereich der zu beschichtenden Oberfläche erreicht bzw. erreichen. Vorzugsweise ist die Stromdichte in der Strömung, die die reaktiven Verbindungen trägt, am Auslass des Strömungshohlkörpers wiederum > 10 mol/(m²s), vorzugsweise > 100 mol/(m²s).

Insbesondere für die Dicke der zu bildenden Schicht relevant ist die Relativbewegung des Substrats gegenüber dem Strömungshohlkörper und auch deren (im Verfahren variabler oder konstanter) Abstand voneinander. In vielen Fällen wird die Relativbewegung vorteilhafterweise konstant gehalten.

Weiterhin ist es vorteilhaft, wenn die reaktiven Verbindungen in einer auf das Substrat gerichteten Gasphasen- oder Aerosolströmung aus dem Strömungshohlkörper austreten. Das Austreten erfolgt dabei vorzugsweise etwa senkrecht zu der zu beschichtenden Substratoberfläche.

Alternativ kann das zu beschichtende oder zu modifizierende Substrat innerhalb des Strömungshohlkörpers angeordnet werden, stromabwärts von einem oder mehreren Filamenten; mit einer derartigen Anordnung lassen sich z.B. Pulverpartikel beschichten, die beispielsweise durch den Strömungshohlkörper rieseln.

Gemäß einer weiteren bevorzugten Ausgestaltung des erfindungsgemäßen Verfahrens wird zumindest eine zweite Gasphase oder ein zweites Aerosol mit der ersten Gasphase bzw. dem ersten Aerosol in Strömungsrichtung vor dem ersten Filament und/oder hinter dem ersten Filament zusammengeführt. Dabei wird gemäß einer weiteren Ausgestaltung die zweite Gasphase oder das zweite Aerosol vor dem Zusammenführen mit der ersten Gasphase oder dem ersten Aerosol an einem bzw. dem zweiten oder einem dritten Filament entlang geführt, so dass die zweite Gasphase oder das zweite Aerosol aktivierte Teilchen bildet. Durch das genannte Zusammenführen mit einer zweiten Gasphase oder einem zweiten Aerosol kann beispielsweise eine zu bildende Beschichtung in ihrer Zusammensetzung oder Beschaffenheit beeinflusst werden. Bei Einsatz von mehr als zwei Gasphasen und/oder Aerosolen und/oder mehr als der angegebenen Zahl von Filamenten gilt das Gesagte entsprechend.

Durch das Zuführen zumindest einer zweiten Gasphase oder eines zweiten Aerosols können weitere Prekursor-Verbindungen zugeführt werden, um weitere reaktive Verbindungen zu bilden; es können hierbei aber auch Stoffe zugeführt werden, die mit der ersten Gasphase oder dem ersten Aerosol reagieren, so dass (a) ein neuer Stoff entsteht, der auf dem Substrat abgeschieden werden kann oder (b) weitere Prekursor-Verbindungen, oder (c) aktivierte Teilchen, oder (d) reaktive Verbindungen entstehen. Der zugeführte Stoff kann auch ein oder mehrere Inertgase umfassen, um weitere Reaktionen, insbesondere die Rückreaktion von reaktiven Verbindungen in nicht-reaktive Verbindungen zu verzögern. Es kann auch ein zusätzlicher Stoff so zugeführt werden, dass sich die Strömungsgeschwindigkeit erhöht und die reaktiven Verbindungen somit schneller auf das Substrat gelangen. Ebenfalls kann ein Stoff zugeführt werden, der die Strömung, die die reaktiven Verbindungen trägt, sichtbar macht, so dass ein zielgerichtetes Leiten der genannten Strömung auf das zu beschichtende Substrat erreicht wird. Weiterhin kann das Zuführen einer zweiten Gasphase oder eines zweiten Aerosols eine Reaktion, Verbindung, Aktivierung oder weiteres Zusammenwirken mit einer dritten oder weiteren Gasphase bzw. einem dritten oder weiteren Aerosol bezwecken.

Das erfindungsgemäße Verfahren ist auch **dadurch gekennzeichnet, dass** die erste und/oder die ggf. vorhandene zweite und/oder eine ggf. vorhandene weitere Gasphase oder das erste und/oder das ggf. vorhandene zweite und/oder ein ggf. vorhandenes weiteres Aerosol als Prekursor-Verbindung eine organische Verbindung und/oder sifiziumorganische Verbindung und/oder metallorganische Verbindung und/oder bor-, phosphor- oder selenorganische Verbindung enthält. Durch die Wahl der Prekursor-Verbindungen wird das Material der zu bildenden Schicht festgelegt.

Die Temperaturen mindestens eines Filamentes liegen bevorzugt zwischen 400 und 5000 K, insbesondere zwischen 500 und 2000 K. Die Temperatur des betreffenden Filamentes muss so hoch sein, dass letztlich (entweder direkt oder nach Ablauf von Folgereaktionen) reaktive Verbindungen entstehen. Hierbei wird über das Filament Energie zugeführt, so dass die Temperatur der reaktiven Verbindung(en) beim Auftragen auf das Substrat auch mit der Strömungsgeschwindigkeit zusammenhängt. Die Filament-Temperatur darf nicht zu hoch gewählt werden, damit keine ungewollten chemischen Reaktionen in einer der Gasphasen und/oder Aerosole erfolgen. Von der Strömungsgeschwindigkeit der eingesetzten Gasphasen und/oder Aerosole und dem Abstand des bzw. der Filamente vom zu beschichtenden Substrat hängt ab, mit welcher Temperatur die Strömung, die die reaktiven Verbindungen trägt, das Substrat erreicht. Insoweit kann die Temperatur eines oder mehrerer Filamente zwar in vielen Fällen höher liegen als die Temperatur, die zu einer Beschädigung des Substrats führen würde. Dennoch ist bei Einstellung der oberen Temperatur des bzw. der Filamente die zulässige Temperatur des Substrates zu berücksichtigen.

Eine Vorrichtung zur Durchführung des erfindungsgemäßen Verfahrens kann umfassen:
- einen Strömungshohlkörper zum Führen einer Strömung einer Gas-phase oder eines Aerosols.
- einen erhitzbaren Filament, das innerhalb des Strömungshohlkörpers so angeordnet ist, dass die Strömung der Gasphase oder des Aerosols entlang des Filaments geführt werden kann,
- eine Quelle für die Gasphase oder das Aerosol und
- eine Leitung, welche die Quelle mit dem Strömungshohlkörper so verbindet, dass die Gasphase oder das Aerosol im Betrieb der Vorrichtung von der Quelle in den Strömungshohlkörper fließen kann.

Der Strömungshohlkörper ist vorzugsweise rohrförmig ausgebildet mit einem vorzugsweise runden Querschnitt. Der Querschnitt kann jedoch auch beliebig anders wie beispielsweise quadratisch oder rechteckig ausgestaltet sein. Ebenfalls kann der Querschnitt in Strömungsrichtung variieren. Das Material des Strömungshohlkörpers sollte temperaturbeständig sein, bezogen auf die Temperatur der darin geführten Strömung. Die der Strömung zugewandte Oberfläche des Strömungshohlkörpers sollte der Ablagerung von Material aus der geführten Strömung gegenüber abweisend sein oder leicht zu reinigen sein.

Das erhitzbare Filament kann insbesondere als Heizdraht ausgestaltet sein, der zum Erhitzen von einem elektrischen Strom durchflossen wird. Der notwendige elektrische Strom wird oftmals mittels eines oder mehrerer Standardnetzteile bereitgestellt werden. Der Begriff "Filament" umfasst im Rahmen des vorliegenden Textes auch Gruppen von zwei oder mehreren einzelnen Filamenten.

Die Quelle für die Gasphase oder das Aerosol kann beispielsweise eine Gasflasche sein. Ebenso ist z.B. eine Mischvorrichtung, die ein Gas wie beispielsweise Luft mit mindestens einem Feststoff und/oder einer Flüssigkeit zu einem Aerosol mischt und für das Verfahren bereitstellt, als Quelle zu verstehen. Auch Umgebungsluft kann die Quelle für eine Gasphase oder ein Aerosol darstellen.

Die Leitung, die die Quelle mit dem Strömungshohlkörper verbindet, kann beispielsweise als Schlauchleitung oder auch als Rohrleitung ausgebildet sein. Ebenfalls kann die Quelle in unmittelbarer Nähe des Strömungshohlkörpers angeordnet sein, so dass dann beispielsweise durch einen Flansch oder auch Rohrabschnitt, wie z,B, auch ein Abschnitt des Strömungshohlkörpers, die Leitung gebildet wird.

Bevorzugt weist der Strömungshohlkörper eine druckoffene Verbindung zur Umgebung auf. Eine solche druckoffene Verbindung ist insbesondere eine Öffnung des Strömungshohlkörpers, aus der im Betrieb die Strömung austritt, um auf das zu beschichtende Substrat geleitet zu werden. Die druckoffene Verbindung muss jedoch keine Austrittsöffnung sein; gemäß einer alternativen Ausgestaltung kann die Strömung das Substrat in Strömungsrichtung noch vor der druckoffenen Verbindung zur Umgebung erreichen, z.B. wenn das Substrat innerhalb des Strömungskörpers angeordnet ist. Es ist jedoch keine den Strömungshohlkörper insgesamt gegenüber der Umgebung druckabschirmende Verbindung vorgesehen.

Gemäß einer weiteren Ausführungsform umfasst der Strömungshohlkörper einer Vorrichtung mindestens ein mischungsfördemdes Mittel zum Zuführen der zweiten und/oder mindestens einer weiteren Gasphase oder des zweiten und/oder eines weiteren Aerosols. Ein solches mischungsfördemdes Mittel kann beispielsweise ein weiterer Rohrstutzen sein, der außen an den Strömungshohlkörper beispielsweise angeschweißt, angeflanscht oder angeklebt ist und über eine Öffnung eine Verbindung zum Innenraum des Strömungshohlkörpers herstellt. Vorzugsweise ist ein solches mischungsfördemdes Mittel so angeordnet, dass eine oder mehrere hierdurch zugeführte weitere

Gasphasen oder Aerosole im Wesentlichen in Strömungsrichtung der Strömung der ersten Gasphase oder des ersten Aerosols zugeführt werden und somit diese Strömung noch unterstützen. Zur Begünstigung der mischenden Wirkung wird ein mischungsfördemdes Mittel vorzugsweise als Düse ausgestaltet.

In einem oder mehreren mischungsfördemden Mitteln ist in manchen Fällen mindestens ein weiteres erhitzbares Filament angeordnet. Die bzw. das durch ein mischungsfördemdes Mittel zugeführte weitere Gas-phase oder Aerosol kann vor dem Eintritt in den Strömungshohlkörper durch entsprechende Heizmittel erhitzt werden. Hierdurch kann beispielsweise ein Abkühlen der vorhandenen Strömung im Strömungshohlkörper vermieden werden. Ein in einem mischungsfördemden Mittel vortellhafterweise angeordnetes Filament kann alternativ oder zusätzlich die darin geführte Gasphase oder das darin geführte Aerosol zum Bilden aktivierter Teilchen anregen.

Besonders bevorzugt weist der Strömungshohlkörper eine druckoffene Austrittsöffnung zum Austreten der Gasphasen- oder Aerosolströmung auf. Eine solche Austrittsöffnung kann beispielsweise einfach als offenes Rohrende ausgestaltet sein. Es sind aber vorzugsweise strömungstechnisch günstige Ausgestaltungen vorgesehen, die beispielsweise zu einer zielgerichteten Strömung führen. Eine solche strömungstechnisch günstige Ausgestaltung kann beispielsweise in Form einer Düse vorliegen. Hierdurch wird die austretende Strömung in manchen Fällen noch beschleunigt.

Vorzugsweise weist die Vorrichtung Mittel zum Erzeugen der Gasphasen- oder Aerosolströmung auf. Ein solches Mittel kann beispielsweise ein Gebläse sein. Alternativ kann die Strömung dadurch erzeugt werden, dass eine Druckpumpe mindestens eine Gasphase oder mindestens ein Aerosol vor der Bereitstellung bzw. der Zuführung zu der erfindungsgemäßen Vorrichtung in einem Behälter unter

Druck setzt, so dass beim Ausströmen aus dem Behälter die Strömung entsteht. Weiter alternativ können ein Ventilator und/oder eine Turbine und/oder eine Pumpe als Mittel zum Erzeugen der Strömung eingesetzt werden.

Ein Schichtsystem, das mittels des erfindungsgemäßen Verfahrens und/oder der Vorrichtung hergestellt ist, umfasst vorzugsweise Silizium und/oder Kohlenstoff und/oder Wasserstoff und/oder Sauerstoff und/oder Stickstoff und/oder Phosphor und/oder Bor und/oder Zinn und/oder Zink und/oder Aluminium und/oder Titan und/oder Selen.

Bei einer erfindungsgemäß hergestellten Beschichtung liegt die Schichtdicke vorteilhafterweise zwischen 0.5 nm und 50 µm; die Beschichtung kann dann insbesondere als haftvermittelnde Schicht oder als Korrosionsschutzschicht oder zur Modifikation der Oberflächenenergie, insbesondere der Benetzungseigenschaften, verwendet werden. Sie kann auch als mechanische oder elektrische oder optische Funktionsschicht auf einem Substrat eingesetzt werden.

Das erfindungsgemäße Verfahren wurde an Probeblechen aus Leichtmetall (Aluminiumlegierung AA 2024) mit einer Fläche von 5 x 10 cm² erprobt. Bevor diese Oberflächen mit dem Verfahren behandelt wurde, sind sie mechanisch gefräst worden. Die so hergestellte frische Metalloberfläche wurde mindestens drei Tage an Raumluft bei Raumtemperatur gelagert. Zum Abscheiden einer Schicht mittels des erfindungsgemäßen Verfahren wurde eine Laboranlage verwendet, die für die Beschichtung von Flachsubstraten geeignet war, Die abgeschiedene Schicht weist die Elemente Silizium, Sauerstoff, Kohlenstoff und Wasserstoff auf.

Die Prüfung der korrosionsinhibierenden Eigenschaften erfolgt durch Auftropfen eines korrosiven Mediums auf das Probeblech, Die Prüflösung besteht aus 3 Gew.-Prozent Natriumchlorid als korrodierend wirkende Substanz in reinstem Wasser.

Die Bewertung des Korrosionsfortschritts erfolgt visuell. Während die unbeschichtete Probe nach vier Stunden Testdauer Korrosionsschäden zeigt, sind im Fall der mit dem erfindungsgemäßen Verfahren beschichteten Oberfläche nach 72 Stunden keine Korrosionsschäden erkennbar.

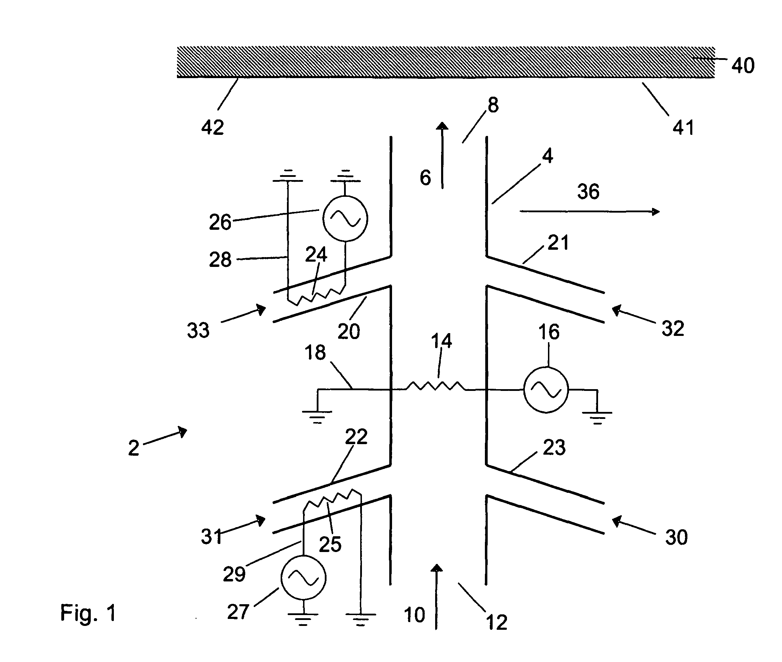

Nachstehend wird die Erfindung an einem Ausführungsbeispiel anhand einer Figur näher erläutert. Es zeigt
- Figur 1: schematisch eine erfindungsgemäße Vorrichtung und ein Substrat mit einer zu beschichtenden Oberfläche im Quer- schnitt.

Figur 1 zeigt eine Beschichtungsvorrichtung 2 und ein Substrat 40. Die Beschichtungsvorrichtung 2 weist einen Strömungshohlkörper 4 auf, in dem eine Strömung 6 geführt wird und an der Austrittsöffnung 8 in Richtung des Substrates 40 austritt. Eine erste Gasphase 10 fließt von einer nicht dargestellten Quelle durch die Zuleitung 12, die hier als Abschnitt des Strömungshohlkörpers 4 ausgebildet ist, in den Strömungshohlkör per 4.

In dem Strömungshohlkörper 4 ist ein erstes erhitztes Filament 14 angeordnet, an dem die erste Gasphase 10 entlang geführt wird. Das erhitzte Filament 14 wird mit Hilfe eines Netzgerätes 16 und einer Zuleitung 18 mit elektrischem Strom versorgt und dadurch beheizt.

An dem Strömungshohlkörper 4 sind vier mischungsfördernde Mittel 20 bis 23 zum Zuführen und Vermischen weiterer Gasphasen bzw. Aerosole zur ersten Gasphase 10 angeordnet. Bei der Vermischung mit der ersten Gasphase kommt es zu chemisch-physikalischen Wechselwirkungen. Dabei sind die mischungsfördemden Mittel 20 und 21 in Strömungsrichtung hinter dem ersten Filament 14 und die beiden mischungsfördemden Mittel 22 und 23 in Strömungsrichtung vor dem ersten Filament angeordnet. Die mischungsfördemden Mittel 20 und 22 sind zusätzlich mit jeweils einem erhitzten Filament 24, 25 versehen, das jeweils von einem Netzteil 26, 27 mit einer elektrischen Zuleitung 28, 29 verbunden ist. Die mischungsfördernden Mittel 20 bis 23 sind auf der vom Strömungshohlkörper 4 abgewandten Seite offen ausgestaltet, so dass sie mit Quellen zum Zuführen weiterer Gasphasen oder Aerosole verbunden werden können.

Bei der Durchführung des erfindungsgemäßen Verfahrens kann der ersten Gasphase 10 z.B. durch das mischungsfördernde Mittel 23 ein Aerosol 30 zugemischt werden. Die Mischung erfolgt, bevor die erste Gas-phase 10 das erste erhitzte Filament 14 erreicht, so dass das gebildete Gemisch das erste erhitzte Filament 14 erreicht und dort erhitzt wird.

Durch das mischungsfördernde Mittel 22 kann der ersten Gasphase 10 z.B. ein zweites Aerosol 31 zugemischt werden, wobei das zweite Aerosol zunächst an dem erhitzten Filament 25 erhitzt wird, so dass es aktivierte Teilchen bildet. Die erste Gasphase 10 vermischt sich so mit dem zweiten Aerosol und den darin enthaltenen aktivierten Teilchen, wobei reaktive Verbindungen entstehen können. Das genannte Gemisch erreicht dann weiter das erste Filament 14, wobei dann gegebenenfalls (weitere) reaktive Verbindungen entstehen.

Der ersten Gasphase 10 bzw. dem durch Zumischen entstehenden Gemisch kann in Strömungsrichtung hinter dem ersten erhitzten Filament 14 eine (weitere) Gasphase 32 durch das mischungsfördernde Mittel 21 zugemischt werden. Hierdurch kann beispielsweise ein Inertgas zugeführt werden, um eine Rückreaktion der reaktiven Verbindungen in Porekursor-Verbindungen zu verzögern.

Durch das mischungsfördernde Mittel 20 kann z.B. ein (weiteres) Aerosol 33, das zunächst an dem erhitzten Filament 24 erhitzt wird, der ersten Gasphase 10 bzw. dem Gemisch zugemischt werden. Durch die Erhitzung des weiteren Aerosols 33 an dem erhitzten Filament 24 können aktivierte Teilchen entstehen, die beim Vermischen mit der ersten Gasphase 10 zu weiteren reaktiven Verbindungen führen können.

Durch die mischungsfördernden Mittel 20 bis 23 können der ersten Gas-phase 10 auch Stoffe zugeführt werden, die sich (ohne vorherige Teilnahme an Reaktionen) als Schicht auf dem Substrat 40 abscheiden und somit die Zusammensetzung der Schicht bestimmen sollen.

Die erste Gasphase 10 verlässt, ggf. zusammen mit den weiteren beigemischten Stoffen, den Strömungshohlkörper 4 als Strömung 6 durch die Austrittsöffnung 8 in Richtung auf das Substrat 40. Die Stromdichte in der Strömung 6 ist dabei größer als 10 mol/(m²s).

Zum Erreichen einer möglichst gleichmäßigen Beschichtung des Substrates 40 wird die Beschichtungsvorrichtung 2 in Bewegungsrichtung 36 mit etwas Abstand entlang der Oberfläche 41, 42 des Substrats 40 geführt. Ebenso gut kann aber auch die Bewegungsrichtung 36 während des Beschichtungsvorgangs mehrfach geändert werden, so dass die Beschichtungsvorrichtung 2 z.B. über dem Substrat 40 hin- und herfährt, um beispielsweise die Schichtdicke zu erhöhen.

Zur Beschichtung einer großen Fläche können mehrere Beschichtungsvorrichtungen gleichzeitig verwendet werden.

Aufgrund der einfachen Handhabung des Verfahrens sowie der einfachen Gestaltung der Vorrichtung, die auch als tragbare Vorrichtung ausgestaltet sein kann, ist neben der Anwendung in automatisierten Fertigungsprozessen auch eine manuelle Handhabung möglich.

## Patentansprüche

1. Verfahren zum Beschichten oder Modifizieren einer Oberfläche, mit folgenden Schritten:
a) Bereitstellen einer ersten Gasphase (10) oder eines ersten Aerosols, umfassend eine oder mehrere Prekursor-Verbindungen, die durch Erhitzen an einem Filament (14) und/oder durch Reaktion mit aktivierten Teilchen in eine oder mehrere reaktive Verbindungen überführbar sind, die (i) auf einem Substrat (40) unter Ausbildung einer Schicht abscheidbar sind oder (ii) eine Substratoberfläche (41,42) modifizieren können, wobei als Prekursor-Verbindung(en) organische Verbindung(en), siliziumorganische Verbindung(en) und/oder metallorganische Verbindung(en) und/oder bor-, phosphor- oder selenorganische Verbindung(en) eingesetzt werden,
b)
- Führen einer Strömung (6) der ersten Gasphase (10) oder des ersten Aerosols entlang eines ersten erhitzten Filaments (14) und/oder
- Führen von nicht-aktivierten Teilchen entlang eines oder des ersten und/oder eines zweiten erhitzten Filaments, so dass sie aktiviert werden, und Zusammenführen einer oder der Strömung (6) der ersten Gasphase (10) oder des ersten Aerosols mit den aktivierten Teilchen, so dass die aktivierten Teilchen mit den Prekursor-Verbindungen reagieren,
so dass die Prekursor-Verbindung(en) in die reaktive(n) Verbindung(en) überführt werden,
wobei die Gesamtteilchenstromdichte in der Strömung (6) nach Erzeugen der reaktiven Verbindung(en) > 10 mol/(m²s) ist,
c) Leiten der einen oder mehreren gemäß Schritt b) gebildeten reaktiven Verbindung(en) auf ein Substrat (40), welches Atmosphärendruck ausgesetzt ist, so dass (i) sich auf diesem eine Schicht abscheidet oder (ii) dessen Oberflächen (41,42) modifiziert wird,
wobei Schritt b) in einem Strömungshohlkörper (4) durchgeführt wird, der die Strömung (6) der ersten Gasphase (10) oder des ersten Aerosols bzw. der nicht-aktivierten Teilchen führt und
das Substrat (40) außerhalb des Strömungshohlkörpers (4) angeordnet ist.

2. Verfahren nach Anspruch 1,
**dadurch gekennzeichnet, dass** die erste Gasphase (10) oder das erste Aerosol mindestens ein Inertgas und/oder Luft enthält.

3. Verfahren nach einem der vorstehenden Ansprüche,
**dadurch gekennzeichnet, dass** die reaktive(n) Verbindung(en) in einer auf das Substrat (40) gerichteten Gasphasen- oder Aerosolströmung (6) aus dem Strömungshohlkörper (4) austreten.

4. Verfahren nach einem der vorstehenden Ansprüche,
**dadurch gekennzeichnet, dass** zumindest eine zweite Gasphase oder ein zweites Aerosol mit der ersten Gasphase (10) bzw. dem ersten Aerosol in Strömungsrichtung
- vor dem ersten Filament (14) und/oder
- hinter dem ersten Filament (14)
zusammengeführt wird.

5. Verfahren nach Anspruch 4,
**dadurch gekennzeichnet, dass** die zweite Gasphase oder das zweite Aerosol vor dem Zusammenführen mit der ersten Gasphase (10) oder dem ersten Aerosol an einem bzw. dem zweiten oder einem dritten Filament entlang geführt wird, so dass die zweite Gasphase oder das zweite Aerosol aktivierte Teilchen bildet.

6. Verfahren nach einem der vorstehenden Ansprüche,
**dadurch gekennzeichnet, dass** die Temperaturen mindestens eines Filamentes zwischen 500 und 2000 K liegen.

## Claims

1. A method of coating or modifying a surface, with the following steps:
a) preparing a first gas phase (10) or a first aerosol, comprising one or more precursor compounds which are capable of being converted by heating on a filament (14) and/or by reaction with activated particles into one or more reactive compounds which (i) are capable of being precipitated on a substrate (40) so as to form a coating or (ii) can modify a substrate surface (41, 42), wherein an organic compound or compounds, an organosilicon compound or compounds and/or an organometallic compound or compounds and/or a boron-, phosphorus- or selenium-organic compound or compounds are used as the precursor compound or compounds,
b)
- passing a flow (6) of the first gas phase (10) or of the first aerosol along a first heated filament (14)
and/or
- passing non-activated particles along a heated filament or the first and/or a second heated filament, so that they are activated, and bringing together a flow or the flow (6) of the first gas phase (10) or of the first aerosol with the activated particles, so that the activated particles react with the precursor compounds,
so that the precursor compound or compounds is or are converted into the reactive compound or compounds,
wherein the overall particle-flow density in the flow (6) after the formation of the reactive compound or compounds is > 10 mol/(m²s),
c) passing the one or more reactive compounds formed in accordance with step b) on a substrate (40) which is subjected to atmospheric pressure, so that (i) a coating is precipitated on the said substrate (40) or (ii) the surface (41, 42) of the said substrate (40) is modified,
wherein step b) is carried out in a hollow flow body (4) which conveys the flow (6) of the first gas phase (10) or of the first aerosol and of the non-activated particles respectively, and
the substrate (40) is situated outside the hollow flow body (4).

2. A method according to Claim 1, **characterized in that** the first gas phase (10) or the first aerosol contains at least one inert gas and/or air.

3. A method according to one of the preceding Claims, **characterized in that** the reactive compound or compounds passes or pass out of the hollow flow body (4) in a gas-phase or aerosol flow (6) directed towards the substrate (40).

4. A method according to any one of the preceding Claims, **characterized in that** at least one second gas phase or one second aerosol is brought together with the first gas phase (10) or the first aerosol respectively in the flow direction
- upstream of the first filament (14) and/or
- downstream of the first filament (14).

5. A method according to Claim 4, **characterized in that** the second gas phase or the second aerosol is conveyed along a filament or the second or a third filament before being brought together with the first gas phase (10) or the first aerosol, so that the second gas phase or the second aerosol forms activated particles.

6. A method according to any one of the preceding Claims, **characterized in that** the temperatures of at least one filament are between 500 and 2000 K.

## Revendications

1. Procédé de revêtement ou de modification d'une surface, ledit procédé comprenant les étapes suivantes :
a) préparation d'une première phase gazeuse (10) ou d'un premier aérosol, comprenant un ou plusieurs composés précurseurs qui peuvent être transformés par chauffage sur un filament (14) ou par réaction avec des particules activées en un ou plusieurs composés réactifs qui (i) peuvent être déposés sur un substrat (40) en formant une couche ou (ii) peuvent modifier une surface de substrat (41, 42), un ou des composés organiques, composés organosiliciés et/ou composés organométalliques et/ou composés organoborés, organophosphorés ou organoséléniés sont utilisés comme composé(s) précurseur(s),
b)
- mener un écoulement (6) de la première phase gazeuse (10) ou du premier aérosol le long d'un premier filament chauffé (14)
et/ou
- mener des particules non activées le long d'un filament chauffé ou du premier filament chauffé et/ou d'un deuxième filament chauffé, de façon à les activer, et mener un écoulement ou l'écoulement (6) de la première phase gazeuse (10) ou du premier aérosol conjointement avec les particules activées de façon à ce que les particules activées réagissent avec le ou les composés précurseurs,
de sorte que le ou les composés précurseurs sont transformés en le ou les composés réactifs,
la densité totale du flux de particules dans l'écoulement (6) après chauffage du ou des composés réactifs étant supérieure à 10 mo/(m²s).
c) diriger l'un ou plusieurs des composés réactifs formés à l'étape b) sur un substrat (40) qui est à la pression atmosphérique de façon à (i) déposer une couche sur ce substrat ou (ii) modifier la surface (41, 42) de celui-ci,
l'étape b) étant réalisée dans un corps d'écoulement creux (4) qui mène l'écoulement (6) de la première phase gazeuse (10) ou du premier aérosol respectivement des particules non activées et
le substrat (40) étant disposé à l'extérieur du corps d'écoulement creux (4).

2. Procédé selon la revendication 1, **caractérisé en ce que** la première phase gazeuse (10) ou le premier aérosol contient au moins un gaz inerte et/ou de l'air.

3. Procédé selon l'une ou plusieurs des revendications précédentes, **caractérisé en ce que** le ou les composés réactifs d'un écoulement de phase gazeuse ou d'aérosol (6) dirigé sur le substrat (40) sortent du corps d'écoulement creux (4).

4. Procédé selon l'une des revendications précédentes, **caractérisé en ce que** au moins une deuxième phase gazeuse ou un deuxième aérosol est amené conjointement avec la première phase gazeuse (10) respectivement le premier aérosol
- an amont du premier filament (14) et/ou
- en aval du premier filament (14)
par référence au sens d'écoulement.

5. Procédé selon la revendication 4, **caractérisé en ce que** la deuxième phase gazeuse ou le deuxième aérosol sont menés le long d'un filament respectivement du deuxième filament ou du troisième filament avant de les amener conjointement avec la première phase gazeuse (10) ou le premier aérosol de façon à ce que la deuxième phase gazeuse ou le deuxième aérosol forment des particules activées.

6. Procédé selon l'une des revendications précédentes, **caractérisé en ce que** les températures d'au moins un filament sont comprises entre 500 et 2000°K,
